# FASCICULE DE BREVET EUROPEEN

(11) **EP 3 030 921 B1**
(45) Date de publication et mention de la délivrance du brevet: **19.06.2019**
(21) Numéro de dépôt: 14750347.8
(22) Date de dépôt: 06.08.2014
(51) Int. Cl.: G01S 13/75, G01B 7/004, G06F 3/00

(54) **DISPOSITIF DE LOCALISATION D'UN OU PLUSIEURS ÉLÉMENTS MOBILES DANS UNE ZONE PRÉDÉTERMINÉE, ET PROCÉDÉ MIS EN OEUVRE DANS UN TEL DISPOSITIF**
VORRICHTUNG ZUM AUFFINDEN EINES ODER MEHRERER MOBILER ELEMENTE IN EINEM VORBESTIMMTEN BEREICH SOWIE IN SOLCH EINER VORRICHTUNG IMPLEMENTIERTES VERFAHREN
DEVICE FOR LOCATING ONE OR MORE MOBILE ELEMENTS IN A PREDETERMINED ZONE, AND METHOD IMPLEMENTED IN SUCH A DEVICE

(30) Priorité: 06.08.2013 FR 1357829
(43) Date de publication de la demande: 15.06.2016
(73) Titulaire: Valotec, 94800 Villejuif (FR); Association Institut de Myologie, 75013 Paris (FR)
(72) Inventeur: LOURME, Jean-Christophe, F-94800 Villejuif (FR); TENDON, Gary, F-92320 Chatillon (FR); HOGREL, Jean-Yves, F-92120 Montrouge (FR)
(74) Mandataire: IPAZ
(86) Numéro de dépôt international: PCT/EP2014/066941
(87) Numéro de publication internationale: WO 2015/018876

(56) Documents cités:
- US-A- 5 136 125
- US-A- 5 853 327
- US-A1- 2001 035 815
- US-A1- 2004 125 312
- US-A1- 2008 186 018

## Description

La présente invention se rapporte à un dispositif et un procédé pour localiser un ou plusieurs éléments mobiles dans une zone prédéterminée. Elle trouve une application particulièrement intéressante dans la mesure de l'activité de plusieurs animaux (rongeurs, etc.) dans une cage. Toutefois, la présente invention est d'un cadre plus large car elle peut s'appliquer à différents domaines. On peut citer notamment :
- La localisation de parties du corps humain, par exemple les doigts d'une main pour réaliser de la sculpture, la modélisation de formes avec les doigts, l'interface homme machine pour ordinateur, etc...,
- La localisation d'objets par rapport à une surface (pions de jeu de société, etc.),
- Interfaces de tablettes graphiques, de dispositifs de pilotage, ...
- Etc.

D'une façon générale, dans le domaine de l'expérimentation animale, il est parfois nécessaire de mesurer les déplacements de plusieurs animaux (rongeurs, etc.) dans une cage. Ces animaux peuvent être des souris, des rats ou autres. De tels rongeurs sont disposés dans une cage associée à un dispositif pour mesurer leurs déplacements. Un tel dispositif est destiné par exemple à l'évaluation de traitement de maladies et au suivi des performances motrices. La réalisation de ce dispositif peut se faire dans le domaine de l'optique, dans le domaine de la mécanique ou dans le domaine électrique.

En optique, on peut utiliser l'infrarouge ou toute caméra dans le visible pour suivre le déplacement de chaque souris. Mais cela comporte de nombreux inconvénients tels que la difficulté d'identifier correctement plus de deux rongeurs, ou encore l'encombrement du dispositif car les rongeurs doivent être « visibles », ...

En mécanique, on peut utiliser la technique de pesée dynamique. Les inconvénients sont une mesure d'activité limitée à un seul rongeur et une trop grande facilité à être parasité par des objets dans la cage (sciure, excréments,...). On peut également utiliser la technique de reconnaissance d'impulsion acoustique, qui présente toutefois les inconvénients d'incapacité d'identification des rongeurs et d'incompatibilité avec la présence de sciure.

Dans le domaine électrique, la technique la plus prometteuse est certainement la radiofréquence. On connait par exemple dans le domaine du jeu, le document US5853327 décrivant une plateforme de jeu pour localiser des pièces que l'on peut déplacer sur la plateforme. Chaque pièce comprend une bobine et un transpondeur pour émettre un identifiant unique en réponse à une excitation provenant d'une bobine placée dans la plateforme. Cette plateforme comporte une matrice de bobines excitatrices. La réponse provenant de la pièce est captée par un enroulement disposé dans la plateforme et distinct des bobines d'excitation. L'alimentation de la pièce se fait soit à partir d'une batterie intégrée, soit à partir du signal d'excitation, dans ce cas la pièce comporte un condensateur de résonance connecté à la bobine intégrée dans la pièce. L'inconvénient d'un tel système est un adressage complexe des bobines d'excitation qui sont excitées une à une Par ailleurs, le document US2001035815 décrit un dispositif comprenant une surface pour détecter la position d'un objet comprenant une puce magnétique. La surface comporte des bobines magnétiques interagissant avec la puce contenue dans chaque objet. La surface comporte une matrice de bobines, chacune d'elles pouvant émettre un signal d'interrogation variable dans le temps de façon à interagir avec les puces magnétiques. La position des puces magnétiques est ensuite affichée. Le document US2004125312 décrit un dispositif d'affichage à cristaux liquides, comprenant un module d'affichage à cristaux liquides, une carte de circuit imprimé située à proximité immédiate d'un support principal du module de dispositif d'affichage à cristaux liquides et un dispositif de fixation pour insérer un numériseur.

La présente invention a pour objectif de remédier aux inconvénients précités en proposant un dispositif de localisation d'éléments mobiles par utilisation du champ magnétique.

Un autre objectif de l'invention est de proposer un dispositif d'identification des éléments mobiles avec une grande efficacité.

Un autre objectif de l'invention est de proposer un dispositif de localisation d'éléments mobiles peu encombrant et capable d'être mis en oeuvre dans un environnement présentant des obstacles telle une cage de souris.

On atteint au moins l'un des objectifs précités avec un dispositif de localisation d'au moins un élément mobile dans une zone prédéterminée, ce dispositif comprenant :
- au moins un module embarqué dans l'élément mobile, ce module embarqué comprenant un circuit électronique et au moins une bobine embarquée pour émettre un signal de localisation,
- une alimentation de ce module embarqué,
   - des bobines réceptrices réparties sur un support à proximité de la zone prédéterminée.

Selon l'invention, chaque bobine réceptrice a pour fonction de capter ledit signal de localisation lorsque l'élément mobile est à proximité ; ce dispositif comprenant en outre :
- une unité de traitement reliée aux bobines réceptrices pour déterminer, par exemple en temps réel ou en temps différé, l'emplacement de l'élément mobile dans la zone prédéterminée par détection d'un niveau de signal ou par des combinaisons de signaux sur ledit support qui est adressé en lignes et colonnes sous forme d'une matrice.

La lecture peut se faire en ligne et colonne d'une matrice pas forcément orthonormée. La répartition des bobines n'est pas forcément uniforme, on peut avoir des zones de forte densité (plusieurs bobines) et des zones de faible densité. L'invention permet de localiser un ou plusieurs éléments mobiles. Les bobines réceptrices peuvent également ne pas être reliées entre elles et peuvent être lues indépendamment.

Par proximité, on entend une distance suffisante pour que des bobines puissent interagir par champ magnétique. L'homme du métier peut déterminer cette distance par expérience et/ou en fonction des caractéristiques magnétiques de chaque composant en jeu.

Selon un exemple de réalisation, les lignes et les colonnes de la matrice sont indépendantes et chaque ligne et chaque colonne est constituée de plusieurs bobines réceptrices reliées en série.

Avec le dispositif selon l'invention, la précision est notamment fonction du nombre de lignes et colonnes de la matrice de bobines réceptrices et de la taille de chaque bobine réceptrice. L'unité de traitement permet de lire notamment séquentiellement ou simultanément toutes les lignes et colonnes de façon à identifier celles qui ont captées une partie du signal de localisation. Une des solutions les plus simples consiste à rechercher ensuite un maximum parmi toutes les lignes et toutes les colonnes ayant captées un signal de façon à en déduire l'emplacement précis de chaque élément mobile. L'emplacement de chaque élément mobile peut ensuite être affiché sur un écran. Certains paramètres du dispositif de localisation (précision, résolution temporelle, ...) peuvent être améliorés par exemple par des méthodes de calcul tel que le calcul de barycentre, interpolation par splines cubiques, la mémorisation de la position précédente des modules embarqués pour sélectionner les antennes à lire au cycle de localisation suivant, etc. Le calcul du barycentre consiste à calculer le barycentre d'un groupe de bobines ayant de préférence captées un signal de localisation. Ce n'est pas le maximum qui est détecté mais le barycentre d'un groupe constituant une zone donnée.

Selon l'invention, on peut récupérer une information de ligne et une information de colonne. C'est le traitement numérique de l'unité de traitement qui peut permettre de déterminer la coordonnée correspondant au croisement entre la ligne de plus grande intensité et la colonne de plus grande intensité, cette méthode étant une première méthode, d'autres plus complexes cités ci-dessus peuvent être mises en oeuvre. Cela permet de simplifier la conception de la matrice de bobines réceptrices par rapport aux matrices de l'art antérieur.

Selon une caractéristique avantageuse de l'invention, l'alimentation peut comprendre une batterie embarquée dans chaque élément mobile. Dans ce cas, une batterie rechargeable ou non est insérée dans ou posée sur l'élément mobile et fournit de l'énergie au circuit électronique.

Selon une variante de l'invention, on peut envisager que l'alimentation comprenne un enroulement magnétique disposé à proximité de la zone prédéterminée de façon à alimenter à distance par champ magnétique chaque modulé embarqué. Dans ce cas, l'alimentation se fait à distance par champ magnétique. L'avantage est que la durée de vie du module embarqué est ainsi augmentée car il ne contient pas de batterie et est alimenté à distance, la bobine embarquée étant par exemple avantageusement utilisée pour recevoir l'énergie magnétique. On peut stocker cette énergie dans un condensateur pour une utilisation ultérieure. L'enroulement peut être plat avec un diamètre permettant d'irradier l'ensemble de la zone prédéterminée.

Selon une autre variante de l'invention, l'alimentation peut être générée par la matrice de bobines réceptrices de façon à alimenter à distance par champ magnétique chaque module embarqué. La matrice de bobines réceptrices comporte une première fonction de réception du signal de localisation et une seconde fonction d'alimentation. De préférence, ces deux fonctions sont réalisées successivement. Cela permet de gagner de la place par rapport à une alimentation par un enroulement supplémentaire indépendante, mais complique la gestion de l'alimentation et de la détection.

Dans le cas d'une alimentation à distance par champ magnétique, le module embarqué comporte de préférence une bobine d'alimentation ayant pour fonction de capter le champ magnétique d'alimentation à distance. Cette bobine d'alimentation et la bobine embarquée peuvent constituer la même la bobine.

En fonction de l'application (localisation, mesures physiologiques, etc.), le module embarqué peut contenir un microcontrôleur, un ASIC ou même un circuit analogique ou numérique simple.

Avec un tel circuit électronique, on dote le module embarqué d'une intelligence avec laquelle il est possible de gérer efficacement la génération du signal de localisation. Le module embarqué peut être paramétré selon le type et la fréquence d'émission du signal de localisation souhaité.

Dans le cas où une seule bobine est utilisée dans le module embarqué, cette bobine permettant de capter le champ magnétique lorsqu'il s'agit d'une télé-alimentation et d'émettre le signal de localisation vers les bobines réceptrices. Afin de conserver une bonne sensibilité quelle que soit l'orientation de la bobine embarquée, on peut envisager que le module embarqué comporte par exemple deux, ou plusieurs bobines embarquées. Dans le cas de l'utilisation de trois bobines, ces trois bobines peuvent être disposées en trièdre et peuvent être disposées en remplacement ou en complément de ladite bobine embarquée. Toutes les fonctions ou une partie des fonctions dédiées à la bobine embarquée peuvent être confiées à ces trois bobines en trièdre. De cette façon quelle que soit le parcours de l'élément mobile dans la zone prédéterminée, son emplacement peut être défini avec précision et exactitude.

Selon une caractéristique avantageuse de l'invention, chaque bobine embarquée peut comporter un noyau de ferrite. Ce noyau de ferrite peut comprendre des extrémités de forme adéquate (demi-sphère, etc.) de façon à canaliser et augmenter le flux de champ magnétique traversant la bobine embarquée ou les bobines disposées en trièdre.

Selon un mode de réalisation de l'invention, la matrice de bobines réceptrices peut comprendre deux sous-matrices électriquement indépendantes comportant chacune plusieurs rangées de bobines réceptrices, ces deux sous-matrices étant superposées et perpendiculaires de façon à former des lignes et des colonnes, la localisation se réalisant en identifiant, dans chaque sous matrice, la rangée la plus proche d'une bobine embarquée émettant un signal de localisation ou par une combinaison des signaux reçus par une ou plusieurs rangées de bobines. Dans une telle disposition, les lignes et les colonnes sont sur deux plans parallèles différents. On peut notamment envisager de réaliser les lignes et/ou les colonnes des bobines sur plusieurs plans de façon à améliorer la résolution de la matrice.

A titre d'exemple non limitatif, la matrice de bobines réceptrices peut être constituée par des bobines plates gravées sur un circuit imprimé ou par tout conducteur sur une surface isolante. Les dimensions de chaque bobine peuvent être de 5mmx5mm.
Selon un autre aspect de l'invention, il est proposé un procédé pour localiser au moins un élément mobile dans une zone prédéterminée, ce procédé comprenant les étapes suivantes :
- alimentation d'au moins un module embarqué dans l'élément mobile, ce module embarqué comprenant un circuit électronique et au moins une bobine embarquée,
- génération d'un signal de localisation par le circuit électronique et émission de ce signal de localisation via la bobine embarquée,
- capture du signal de localisation au moyen de bobines réceptrices réparties sur un support à proximité de la zone prédéterminée ; chaque bobine ayant pour fonction de capter ledit signal de localisation lorsque l'élément mobile est à proximité,
- détermination en temps réel ou en temps différé de l'emplacement de l'élément mobile dans la zone prédéterminée par détection d'un niveau de signal sur ledit support qui est adressé en lignes et colonnes sous forme d'une matrice au moyen d'une unité de traitement reliée à ce support. On peut utiliser une combinaison des signaux reçus par une ou plusieurs rangées de bobines pour déterminer l'emplacement de l'élément mobile.

Pour un contrôle efficace de la consommation d'énergie, on peut prévoir une alimentation effectuée de façon périodique ; en phase d'alimentation, on stocke de l'énergie dans chaque module embarqué pour une utilisation ultérieure en phase de non alimentation. Typiquement, on alimente des moyens de stockage d'énergie, tels qu'un condensateur, pendant la phase d'alimentation, puis on coupe l'alimentation et on génère le signal de localisation de façon à déterminer l'emplacement de l'élément mobile.

Avantageusement, la génération d'un signal de localisation peut être réalisée à un instant différent pour chaque module embarqué de façon à réaliser un multiplexage à accès multiple à répartition dans le temps (TDMA) pour distinguer les modules embarqué les uns des autres. Le signal de localisation peut être sous la forme d'une impulsion qui sera captée par la matrice de bobines réceptrices. Dans ce mode de réalisation, on peut prévoir un signal de synchronisation qui peut être la fin de la phase d'alimentation ou tout autre signal de synchronisation émis par exemple par un enroulement d'alimentation ou par la matrice de bobines réceptrices. A partir de ce signal de synchronisation, chaque module embarqué peut comprendre un compteur permettant l'émission du signal de localisation à un instant prédéterminé qui est différent pour chaque module embarqué. Ainsi, à la réception, l'unité de traitement peut aisément associer chaque signal de localisation avec le module embarqué qui en est à l'origine. Pour cela, il suffit par exemple de mesurer la durée entre le signal de synchronisation et la réception du signal de localisation.

Selon un autre mode de mise en oeuvre, la génération d'un signal de localisation est réalisée par génération d'un signal de fréquence prédéterminée et différente pour chaque module embarquée de façon à réaliser un multiplexage à accès multiple par répartition en fréquence (FDMA) pour distinguer les modules embarqué les uns des autres. Les modules embarqués peuvent émettre en même temps chacun un signal de localisation de type fréquentiel. Ces signaux fréquentiels peuvent être captés quasiment en même temps par la matrice de bobines réceptrices. Dans ce mode de réalisation, à la réception, l'unité de traitement est configurée pour identifier la fréquence de chaque signal de localisation ; chaque fréquence permettant d'identifier le module embarqué correspondant. On peut également envisager une combinaison des deux modes ainsi décrits. En effet, les modules embarqués peuvent émettre des signaux de localisation sous forme de signaux fréquentiels à des instants différents.

Selon un mode de réalisation avantageux, chaque signal de localisation peut contenir un identifiant unique. Il s'agit en fait de coder le signal de localisation pour simplifier la correspondance entre signal de localisation et le module embarqué correspondant.

Le circuit électronique et la bobine embarquée constituent un circuit RLC qui oscille en générant le signal de localisation. L'oscillation peut même être très amortie. Pour créer une surtension dans le signal de localisation et le rendre ainsi plus facilement détectable, on interrompt brusquement le courant à travers la bobine embarquée de façon à générer un signal de localisation. Il s'agit d'une brusque variation du courant à travers la bobine, de préférence lorsque le courant a sa valeur la plus élevée. On crée notamment une discontinuité induisant une surtension relativement élevée que la matrice de bobines réceptrices pourra capter efficacement.

D'autres avantages et caractéristiques de l'invention apparaîtront à l'examen de la description détaillée d'un mode de mise en oeuvre nullement limitatif, et des dessins annexés, sur lesquels :
La figure 1 est une vue schématique d'une main en mouvement devant un écran de téléviseur, de téléphone ou autre, conformément au dispositif selon l'invention,
La figure 2 est une vue schématique d'un dispositif de mesure de l'activité d'une souris selon la présente invention,
La figure 3 est un schéma électronique simplifié d'une bobine embarquée connectée à un circuit électronique pour la génération du signal de localisation,
La figure 4 est une vue schématique de trois noyaux de ferrite pouvant s'intégrer dans une bobine embarquée de façon à en améliorer les performances,
Les figures 5 et 6 sont des vues schématiques de bobines embarquées disposées en trièdre afin d'améliorer le couplage avec un dispositif de télé-alimentation et la localisation, notamment tridimensionnelle,
La figure 7 est un schéma électronique interne simplifié du circuit électronique connecté à la bobine embarquée,
La figure 8 est une courbe représentant un signal de localisation émis par le module embarqué, ce signal étant sous la forme d'un signal oscillant amorti,
La figure 9 est une courbe représentant un signal de localisation émis par le module embarqué, ce signal étant sous la forme d'un signal oscillant très amorti,
La figure 10 est une courbe représentant un signal de localisation émis par le module embarqué, ce signal étant sous la forme d'une impulsion qui comporte une surtension remarquable au niveau de la détection,
La figure 11 est une vue schématique illustrant le mode opératoire pour la génération d'une impulsion selon l'invention,
La figure 12 est une vue schématique simplifiée d'un circuit électronique à l'intérieur d'un module embarqué selon l'invention,
La figure 13 est une vue schématique simplifiée illustrant la disposition de bobines en lignes et colonnes dans une matrice selon l'invention,
La figure 14 est une courbe obtenue par simulation illustrant la force contre-électromotrice (efficace) produite aux bornes d'une ligne de vingt antennes, à 1cm d'un plan de déplacement d'une bobine émettrice,
La figure 15 est une vue schématique illustrant le principe de fonctionnement du dispositif selon l'invention,
La figure 16 est une vue schématique illustrant un mode d'identification par multiplexage à accès multiple à répartition dans le temps (TDMA), et
La figure 17 est une vue schématique illustrant un mode d'identification par multiplexage à accès multiple par répartition en fréquence (FDMA).

La présente invention peut avantageusement s'appliquer à de nombreux domaines. Dans ce qui suit, seuls deux modes de réalisation seront décrits, d'autres modes de réalisation peuvent aisément être envisagés ou déduits à partir de la présente description.

Dans un premier mode de réalisation, on va décrire l'application du dispositif selon l'invention dans le domaine de l'affichage pour élaborer un écran interactif 3D.

Dans un second mode de réalisation, on va décrire un dispositif de mesure de l'activité de plusieurs animaux, en particulier plusieurs souris dans une cage. Bien évidemment la présente invention peut de la même manière s'appliquer à différents animaux autres que des souris.

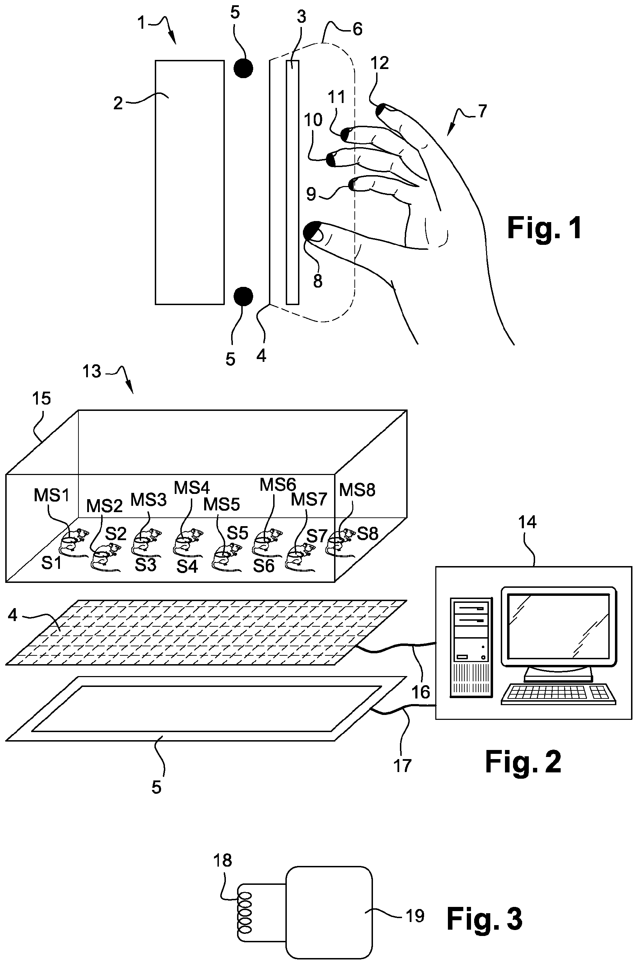

Pour illustrer le premier mode de réalisation, on voit sur la figure 1 un schéma très simplifié illustrant un écran 1, notamment tactile. Cet écran est dit interactif tridimensionnel car il peut recevoir des consignes à partir d'une main 7 positionnée à distance de l'écran. Un tel écran 1 comprend un panneau arrière 2 comprenant des moyens matériels et logiciels, notamment une unité de traitement pour le traitement de données et l'affichage. Un panneau avant 3, de préférence en verre transparent, est disposé du côté avant de l'écran 1. Ce panneau sert également de protection des composants internes de l'écran. Selon l'invention, on insère une matrice de bobines réceptrices 4 et un enroulement d'alimentation 5 entre le panneau arrière 2 et le panneau avant 3. L'enroulement 5 peut se trouver du côté interne comme représenté sur la figure 1 ou bien du côté extérieur. D'autres formes et moyens d'alimentation peuvent être envisagés. Cet enroulement d'alimentation 5 a pour but d'alimentation à distance par champ magnétique des modules embarqués 8-12 disposés dans des doigts de la main 7. Les doigts peuvent être considérés comme des éléments mobiles. Chaque module embarqué 8,...,12 comporte une intelligence lui permettant d'émettre un signal de localisation destiné à être capté par la matrice de bobines réceptrices 4. Cette dernière est conçue de sorte qu'après traitement par une unité de traitement, on peut déterminer l'emplacement de chaque module embarqué. En fonction de la position de chaque extrémité de doigt où se trouve un module embarqué, des actions peuvent être générées ; Par extension, on peut idéalement suivre les mouvements d'un ou plusieurs modules embarqués de façon à identifier des gestes faisant office de commande. Ces gestes sont d'abord interprétés par l'unité de traitement avant d'en déduire des commandes.

Dans l'exemple de la figure 1, la matrice de bobines réceptrices est disposée en sandwich entre l'alimentation 5 et le panneau avant 3. On peut envisager d'autres dispositions à condition que l'alimentation puisse alimenter convenablement les modules embarqués 8 à 12 et que la matrice de bobines réceptrices puisse recevoir des signaux de localisation émis par les modules embarqués. L'alimentation 5 peut se trouver en sandwich entre la matrice 4 et le panneau avant 3.

Sur la figure 1, la référence 6 désigne une zone prédéterminée, c'est-à-dire un volume dans lequel les modules embarqués sont détectables. Cette zone prédéterminée 6 est définie par les caractéristiques physiques des bobines réceptrices arrangées dans la matrice 4. La zone prédéterminée 6 représente la zone d'influence de ces bobines réceptrices. L'alimentation 5 doit également être convenablement dimensionnée pour alimenter les modules embarqués se trouvant dans la zone prédéfinie.

En pratique, les modules embarqués peuvent être intégrés dans des gants portés par un utilisateur 7. Ces modules embarqués peuvent aussi être des dispositifs électroniques conçus pour être maintenus en extrémité des doigts de l'utilisateur 7.

Le schéma de la figure 1 n'est pas à l'échelle. L'écran 1 peut être un écran d'ordinateur, un téléviseur, un téléphone portable, un « smartphone » ou tout autre dispositif d'affichage ou plus simplement un dispositif d'entrée avec ou sans contact (sans affichage) relié à une unité de traitement.

On va maintenant décrire un mode de réalisation mettant en oeuvre un dispositif selon l'invention permettant de mesurer les déplacements de plusieurs souris dans une cage par exemple de type Eurostandard Type II (267 x 207 x 140 mm).

Ce dispositif est destiné à l'évaluation de traitement de maladies et au suivi des performances motrices. Cet axe de recherche prioritaire se justifie par le besoin d'améliorer le suivi quantitatif des essais cliniques notamment dans le cadre de l'évaluation de thérapies pharmacologiques, géniques ou cellulaires.

Sur la figure 2 on voit un tel dispositif de mesure globalement référencé par 13 et relié à un ordinateur 14. Ce dernier peut comprendre une unité de traitement doté de moyens matériel et logiciel adéquats et connus en soi pour notamment communiquer avec le dispositif de mesure 13. L'unité de traitement peut comprendre un microprocesseur posé sur une carte mère, de la mémoire vive, une alimentation, un disque dur, des moyens d'entrées conventionnels et des cartes d'extension connectées au dispositif de mesure 13. Des moyens logiciels peuvent être développés pour commander le dispositif de mesure 13 et traiter les données provenant de ce dispositif de mesure 13 de façon à afficher la progression des souris sur un écran d'affichage.

Le microprocesseur permet notamment de mettre en oeuvre les étapes du procédé selon l'invention.

Le dispositif de mesure 13 selon l'invention permet de localiser en temps réel par exemple huit souris S1 à S8 sur une surface de 267mm x 207mm, ce qui correspond au fond d'une cage 15 Eurostandard Type II. Les souris sont libres de déplacement dans cette cage 15.

Un module embarqué MS1 à MS8 est implanté dans chaque souris S1 à S8 respectivement et émet régulièrement un signal électromagnétique permettant de le localiser grâce à la matrice de bobines réceptrices 4. Cette matrice peut fonctionner sur le même principe que la matrice décrite sur la figure 1, mais peut toutefois s'en différencier par des caractéristiques physiques et géométriques. La matrice de bobines réceptrices 4 est disposée sous la cage 15 et présente sensiblement les mêmes dimensions que le fond de la cage 15. Dans le cas présent, la matrice 4 est plane, rectangulaire et positionnée parallèlement au fond de la cage 15.

Les modules embarqués MS1 à MS8 ne comportent pas de batterie. Ils sont alimentés à distance (téléalimentation) par l'enroulement 5 qui est disposé sous la matrice de bobines réceptrices 4. Mais d'autres dispositions peuvent être envisagées comme par exemple au-dessus de la cage 15. Pour des raisons d'encombrement, la matrice de bobines réceptrices 4 et l'enroulement 5 peuvent être placés solidaires l'une de l'autre dans un boîtier (non représenté), l'ensemble constituant un support capable de recevoir la cage 15. La cage 15 peut être posée de façon amovible. On peut ainsi utiliser différentes cages sur un même support.

Le dispositif de mesure 13 fonctionne avec une liaison à l'ordinateur 14 sur lequel la position des souris à localiser est affichée en temps réel et enregistrée. On peut prévoir dans l'ordinateur 14 une carte d'extension pour alimenter et échanger des données avec la matrice de bobines réceptrices 4 via une liaison câblée 16 ou sans fil. On peut également prévoir une carte d'extension dans l'ordinateur 14 pour commander l'alimentation de l'enroulement 5 via une liaison 17.

La précision spatiale de localisation est de 5mm et la résolution temporelle de 1 seconde. La précision de localisation dépend de la géométrie des bobines réceptrices qui servent d'antennes réceptrices.

La matrice de bobines réceptrices 4 et l'enroulement 5 peuvent être disposés dans un boîtier avec d'autres composants permettant de relayer les signaux entre le dispositif de mesure 13 et l'ordinateur 14. Les dimensions du dispositif de mesure sont telles que ces dispositifs de mesure peuvent être utilisés dans des portoirs de cages de souris.

Avec un tel dispositif de mesure, l'enroulement 5 télé-alimente les modules embarqués MS1 à MS8 qui à leur tour génèrent et émettent des signaux de localisation qui sont captés par la matrice de bobines réceptrices 4. Cette dernière est conçue de façon à pouvoir déterminer l'emplacement de chaque module embarqué. Pour ce faire, on utilise un ordinateur 14 pour commander le dispositif de mesure et traiter les données provenant de la matrice de bobines réceptrices. On peut ainsi suivre le déplacement en temps réel de chaque souris.

En complément de ce qui précède, sur la figure 3 on voit un schéma illustrant un module embarqué MS1,..., MS8. Chaque module embarqué comprend une bobine embarquée 18 et un circuit électronique 19. Ce dernier est doté de composants électroniques et d'un microcontrôleur permettant la génération d'un signal de localisation à des moments prédéterminés, de façon régulière ou non.

Plus précisément, l'alimentation à distance (télé-alimentation) des modules embarqués se fait par couplage inductif entre la bobine embarquée 18 et l'enroulement 5. L'enroulement 5 est une bobine placée à proximité de la cage 15, et émet un champ magnétique dans toute la zone de détection, de façon à alimenter les modules embarqués quelles que soient leurs positions et leurs orientations dans la cage.

Ce champ magnétique variable induit des tensions aux bornes des bobines embarquées à l'intérieur des modules embarqués et sert à alimenter les circuits électroniques 19.

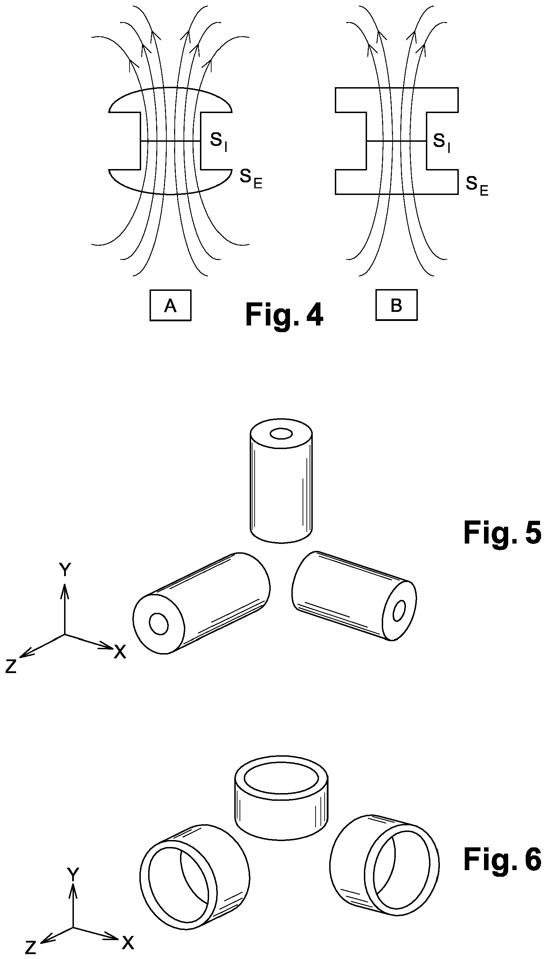

Avantageusement, des noyaux de ferrite peuvent être utilisés dans les bobines embarquées 18 pour augmenter les performances de télé-alimentation. La géométrie des noyaux de ferrite peut permettre de rendre le système moins sensible à l'orientation des modules embarqués. Ainsi, un noyau de ferrite avec des extrémités en « demi-sphère » comme représenté en A sur la figure 4 permet de canaliser une partie du champ magnétique émis par l'enroulement 5 de télé-alimentation, même lorsque l'axe du noyau de ferrite est orthogonal à l'axe de l'enroulement 5 émetteur du champ de télé-alimentation.

D'une façon générale, pendant l'utilisation, il est possible que la bobine embarquée destinée à émettre le signal de localisation soit mal orientée. Cela peut notamment se produire lorsque son axe ne permet pas de couplage avec la matrice de bobines réceptrices. Dans ce cas, le signal de localisation reçu est trop faible pour être exploité en vue de localiser le module embarqué. Une des solutions pour corriger cet état est par exemple l'utilisation de plusieurs bobines émettrices orientées différemment dans chaque module embarqué. Le schéma de la figure 5 illustre une telle topologie de bobines émettrices du signal de localisation disposées en trièdre. En effet, on utilise trois bobines à la place d'une seule. Ces trois bobines sont disposées selon trois axes orthogonaux et émettent un même signal de localisation. On peut envisager d'autres configurations. Ainsi, quelle que soit l'orientation du module embarqué par rapport à la matrice, les antennes réceptrices reçoivent toujours un ou plusieurs signaux de niveau suffisamment élevé provenant du module embarqué.

On peut aussi envisager d'exploiter les signaux de localisation émis par une ou plusieurs bobines émettrices afin de connaitre en plus de la position, l'orientation (rotation autour des axes X, Y et Z) et même la direction (en associant plusieurs modules émetteurs ou en utilisant plusieurs bobines émettrices) du module embarqué.

De façon générale, on peut imaginer multiplier les orientations des bobines émettrices et réceptrices pour par exemple améliorer la localisation et la télé-alimentation des modules embarqués.

En plus de ces dispositions géométriques des bobines émettrices permettant d'optimiser la localisation, on peut imaginer une optimisation de l'utilisation de ces différentes bobines. Par exemple suivant la position spatiale d'un émetteur donné, la ou les bobines émettrices les mieux disposées géométriquement de cet émetteur dans un plan donné pour la localisation pourrait être d'avantage utilisée que les autres bobines émettrices du même module embarqué. Ce principe peut aussi être mis en oeuvre pour l'alimentation à distance des modules embarqués si ceux-ci sont par exemple alimentés à l'aide d'un champ magnétique émis par la matrice de bobines réceptrices.

Les bobines de la figure 5 sont des bobines allongées comprenant un noyau de ferrite. La forme de ces bobines est un cylindre allongé, la hauteur selon l'axe de révolution étant supérieure au diamètre du cylindre.

Sur la figure 6, on voit un autre exemple de forme de bobines représentées sur la figure 5. Il s'agit de cylindre plat ayant une hauteur inférieure au diamètre du cylindre.

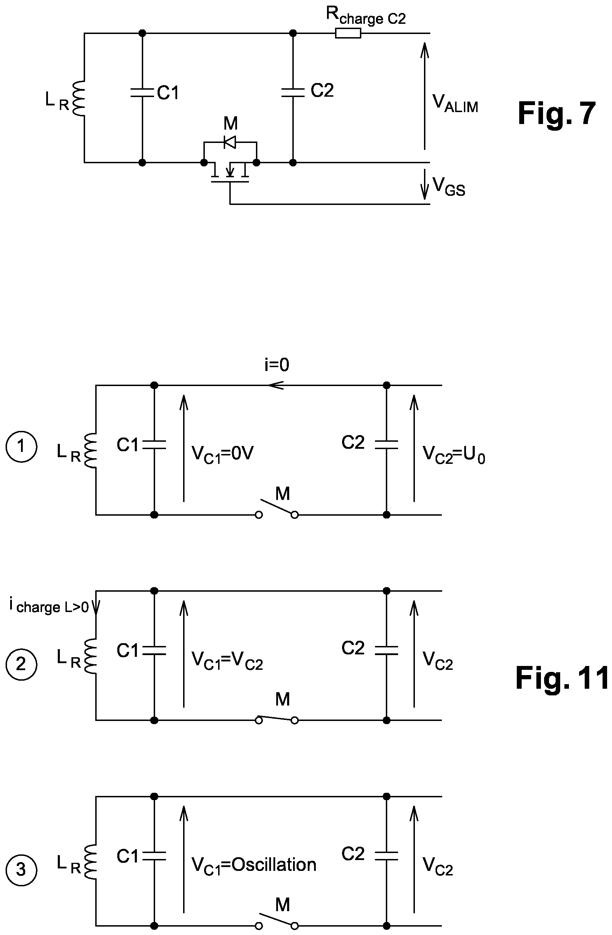

L'énergie reçue par les bobines embarquées permet d'alimenter le circuit électronique de chaque module embarqué de façon à générer des impulsions en provoquant une brusque variation du courant à travers la bobine LR comme représentés sur la figure 7. La bobine LR peut être la même que la bobine utilisée pour recevoir l'énergie. Sur la figure 7, on voit un schéma électronique simplifié dans lequel LR et C1 sont disposés en parallèle. A une extrémité de C1, on connecte un deuxième condensateur de plus grande capacité C2. Entre les autres extrémités de C1 et de C2, on dispose un interrupteur M qui peut être un transistor MOSFET. La tension d'alimentation Valim du module embarqué est utilisée pour charger le condensateur C2 via une résistance de charge RchargeC2.

Pour générer le signal de localisation qui est avantageusement un champ magnétique, on prévoit de faire circuler un courant électrique variant au cours du temps à travers la bobine LR comportant une ou plusieurs spires. Deux des méthodes de génération d'un signal permettant la localisation sont la mise en résonance/oscillation du condensateur C1 et de la bobine LR et la variation brusque du courant à travers la bobine LR. D'une façon générale, le signal de localisation peut être crée de la manière suivante:
- un ou plusieurs condensateurs chargés en tension peuvent se décharger dans une ou plusieurs bobines,
- Une brusque variation des courants traversant une ou plusieurs bobines peut être provoquée

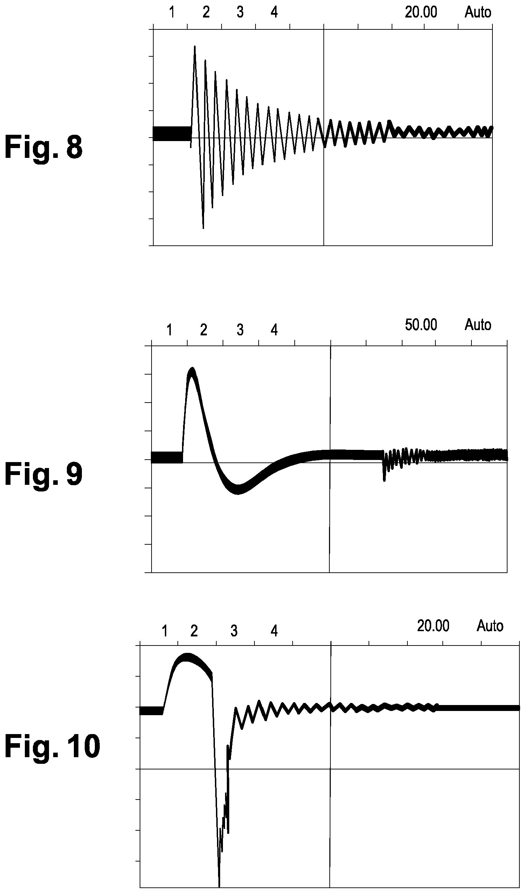

Les figures 8 à 10 illustrent trois courbes représentant trois solutions de signal de localisation généré par le module embarqué.
- **Solution 1 :** le principe est de décharger un condensateur dans une bobine dans un mode pseudo-oscillant peu amorti. La figure 8 est une courbe représentant l'allure de la tension induite dans la matrice de bobines réceptrices.
- **Solution 2 :** le principe est de décharger un condensateur dans une bobine dans un mode pseudo-oscillant très amorti. La figure 9 est une courbe représentant l'allure de la tension induite dans la matrice de bobines réceptrices.

Cette seconde solution permet de générer dans la matrice de bobines réceptrices une impulsion plus longue temporellement et ayant une amplitude plus élevée que celle de la solution n°1.
- **Solution 3 :** le principe est d'augmenter fortement la tension induite dans la matrice de bobines réceptrices en provoquant une variation rapide du courant dans une inductance. Pour ce faire, on fait circuler un courant à travers une inductance et on fait varier brusquement ce courant électrique. Cette brusque variation de courant provoque une variation brusque du flux du champ magnétique généré par l'inductance. Une variation rapide du flux magnétique émis par un module embarqué entraine une tension induite élevée dans la matrice de bobines réceptrices car les tensions induites aux bornes des bobines réceptrices augmentent avec la variation du flux magnétique les traversant. La figure 10 est une courbe représentant l'allure de la tension induite dans la matrice de bobines réceptrices. Cette troisième solution est celle qui est revendiquée.

La tension induite générée est plus élevée que dans les deux précédentes solutions dans des conditions similaires.

On peut imaginer un système permettant de forcer la brusque variation du courant traversant l'inductance émettrice du signal de localisation quand celui-ci atteint son maximum. Ainsi la tension créée aux bornes des antennes réceptrices sera maximale. Cette recherche de maximum peut être faite par exemple par calcul, par détection du courant maximal ou autre.

A titre d'exemple, les illustrations de la figure 11 décrivent un mode de mise en oeuvre du circuit électronique pour la génération d'un signal de localisation qui est avantageusement une impulsion telle que décrite dans la troisième solution qui est celle revendiquée. Sur la figure 11, on retrouve de façon encore simplifiée des composants électroniques déjà illustrés sur la figure 7.

L'inductance LR et le condensateur C1 sont en parallèle. C2 est un condensateur de grande valeur initialement chargée à U0 et M l'interrupteur pilotable réalisé par exemple avec un transistor ou autre. Les étapes pour générer le signal de localisation peuvent être les suivantes.

Dans une première phase, on stocke l'énergie dans le condensateur C2 :
**Phase 1** : énergie stockée dans C2
- M est ouvert
- V_{C1} =0V
- aucun courant ne traverse LR, ni C1
- V_{C2} = U₀

Dans une deuxième phase, on transfert l'énergie dans la bobine LR :
**Phase 2** : transfert d'énergie dans LR
- M est fermé
- V_{C1} = U₀
- LR se charge en courant

Dans une troisième phase, on crée une surtension :
- **Phase 3** : variation brusque du courant ichargeL traversant LR
- M est ouvert
- La grande variation de courant ichargeL due à l'ouverture brusque de M entraine une variation brusque du flux magnétique généré par l'inductance LR et donc une tension induite élevée aux bornes des bobines réceptrices.

Ainsi, le signal de localisation peut être un signal résonant amorti en mettant le circuit LR et C1 en résonance, ou bien la rendre plus caractéristique en mettant en oeuvre la variation brusque décrite ci-dessus.

Il est possible de réaliser d'autres topologies en modifiant le placement et le nombre de composants (LR, C1, C2, M, etc.) et le choix des composants (LR avec une faible résistance série, etc.) afin d'optimiser le signal de localisation reçu par la matrice de bobines réceptrices.

D'une façon générale, pour localiser les modules embarqués, une ou plusieurs antennes réceptrices peuvent être utilisées. Ces antennes peuvent par exemple former une matrice d'antennes (en étant mises côtes à côtes) pour localiser les modules émetteurs. Chaque antenne est avantageusement une bobine de sorte qu'on obtient une matrice de bobines réceptrices 4 telle que représentée par exemple sur les figures 1 et 2.

D'autres topologies qu'une matrice d'antennes peuvent être imaginées. Le motif de disposition des antennes n'est pas forcément régulier. On peut par exemple imaginer placer des antennes réceptrices qu'à certains endroits où l'on souhaite détecter la position d'un module embarqué. Le cas le plus classique serait une disposition régulière des antennes réceptrices sous formes de matrice. La matrice d'antennes réceptrice n'est pas forcément plane et n'est pas forcément unique. On peut imaginer q matrices ou sous-matrices (q étant un entier supérieur ou égal à 1) placées de façon orthogonales ou non pour calculer la position d'un ou plusieurs modules embarqués dans l'espace (localisation dans un volume).

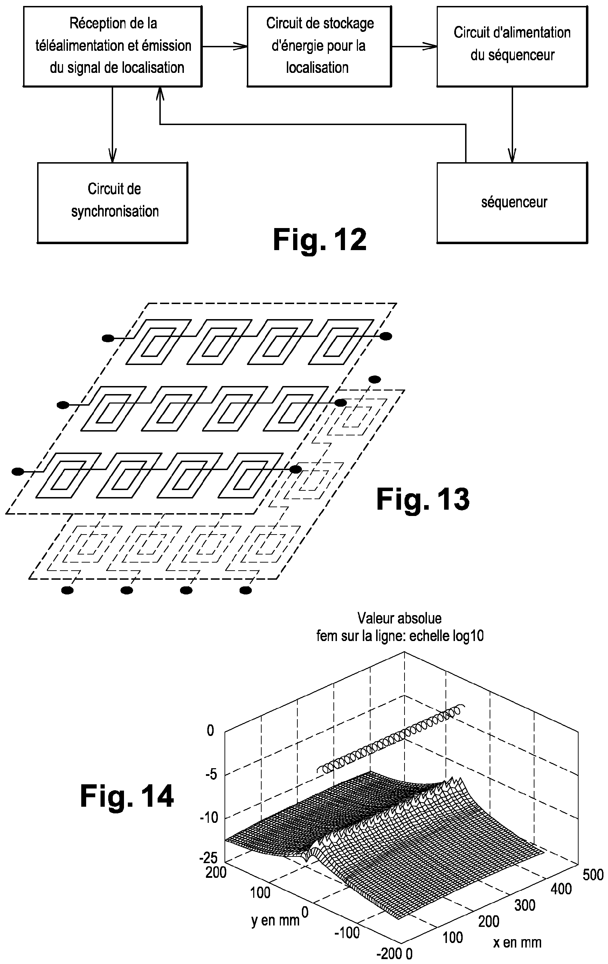

Pour simplifier l'électronique de mesure, il est possible de réduire le nombre de voies (sortie d'antennes) à mesurer. Cela peut se faire en câblant les antennes réceptrices en série ou par groupe d'antennes. Ces antennes en série peuvent ensuite être disposées en lignes et colonnes d'antennes pour pouvoir déterminer la position des modules embarqués (voir figure 13). On calcule alors la position du module embarqué en exploitant les niveaux reçus sur les lignes et les colonnes réceptrices sur lesquelles les signaux sont reçus.

Les antennes réceptrices peuvent être réalisées sur circuit imprimé souple ou rigide et peuvent être présentes sur plusieurs couches du circuit imprimé pour avoir plus de spires par exemple ou encore une densité plus élevée d'antennes réceptrices. Les antennes réceptrices peuvent également être des bobines de type solénoïde, pour améliorer le niveau des signaux reçus.

De façon générale, on peut imaginer que les antennes réceptrices soient réalisées (impression, dépôt, etc.) sur tous types de support souple ou rigide, opaque ou transparent. Par exemple, il est possible de placer une matrice d'antennes transparentes au-dessus d'une surface où l'on souhaite déterminer la position de module(s) embarqué(s) (vitre, écran d'ordinateur, etc.). Une matrice d'antennes pourrait par exemple être réalisée en Oxyde d'indium-étain qui est un conducteur transparent utilisé aussi pour les écrans tactiles.

Sur la figure 12 est illustré un exemple de réalisation d'un circuit électronique de module embarqué. On distingue cinq fonctions principales :
**Fonction 1** : circuit de réception de la téléalimentation et émission du signal de localisation. Dans la plus simple configuration, cet étage peut être composé d'un circuit LC parallèle accordé qui sert à recevoir l'énergie de la téléalimentation dans un premier temps (transformation de l'énergie émise sous forme d'un champ magnétique en courant électrique exploitable pour alimenter les éléments du module embarqué) et qui sert à émettre le signal de localisation dans un deuxième temps (émission d'un champ magnétique qui sera capté pour localiser le module embarqué).
**Fonction 2 :** circuit de stockage de l'énergie pour sa localisation : Cet étage stocke une partie de l'énergie reçue de la téléalimentation qui servira à créer le signal de localisation. Dans la plus simple configuration, cet étage peut être composé d'un condensateur. Durant la phase de téléalimentation, ce condensateur accumule l'énergie. Après la phase de téléalimentation vient une phase d'attente durant laquelle le condensateur stocke l'énergie. Enfin, durant la phase de localisation, l'énergie accumulée dans ce condensateur est transmise à l'étage d'émission du signal de localisation pour créer le signal de localisation.
**Fonction 3 :** circuit d'alimentation du séquenceur : cet étage stocke une partie de l'énergie reçue de la téléalimentation pour alimenter un séquenceur F5 du module embarqué. On désigne par séquenceur l'ensemble du circuit servant à déclencher le signal de localisation.
**Fonction 4 :** circuit de synchronisation : Le circuit de synchronisation permet de détecter le début et la fin des phases de téléalimentation pour que le module puisse émettre le signal de localisation au moment voulu, c'est-à-dire quand la phase de téléalimentation est terminée. (Cet étage est notamment utile quand la méthode de la TDMA est employée pour l'identification des modules embarqués entre eux).
**Fonction 5 :** circuit séquenceur : Le séquenceur est l'ensemble du circuit servant à déclencher le signal de localisation. A partir du signal de synchronisation, le séquenceur permet de déclencher l'émission du signal de localisation au moment voulu. Quand la méthode de la TDMA est employée pour l'identification des modules embarqués entre eux, chaque module embarqué émet son signal de localisation à un instant différent après la phase de téléalimentation.

Sur l'exemple de la figure 13, les antennes réceptrices sont des bobines gravées sur circuit imprimé et permettent d'avoir une précision de 5mm. Cette solution présente l'avantage d'être moins couteuse que l'utilisation de bobines « classiques » en plus d'être facilement réalisable. Les bobines réceptrices sont disposées en lignes et colonnes. On prévoit deux couches superposées. Une première couche sur la face supérieure et comprenant plusieurs rangées de bobines plates en série. On distingue également une seconde couche sous la première couche et comprenant plusieurs rangées de bobines plates en série. Les rangées de la première couche sont perpendiculaires aux rangées de la seconde couche de sorte que l'on constitue une matrice adressable en lignes et colonnes. La position d'un module embarqué est signalée par le lieu d'intersection d'une ligne et d'une colonne ayant captés le niveau de signal de localisation le plus élevé.

Les extrémités des rangées comportent des connecteurs pour transmettre les signaux vers l'unité de traitement dans l'ordinateur 14.

Sur la figure 14, on voit une courbe simulée représentant la force contre-électromotrice induite (en Volts efficace) dans une ligne de vingt antennes pour une bobine émettrice se déplaçant sur un plan à une altitude de 1cm de la ligne réceptrice. La bobine émettrice est la bobine embarquée avec une spire, un courant d'excitation de 1mAeff à une fréquence de 1kHz, et un diamètre de 1cm.

On va maintenant décrire des exemples de modes fonctionnels du dispositif selon l'invention.

Le principe général consiste à localiser un ou plusieurs éléments (modules embarqués) se déplaçant par rapport à une matrice de bobines réceptrices ou l'inverse.

Le dispositif de localisation selon l'invention est constitué :
- de différents modules émetteurs (= modules embarqués) : S1, S2, S3, ..., Sn (n étant un entier supérieur ou égal à 1)
- d'une matrice comportant 1 à p antennes (p étant un entier supérieur ou égal à 1)
- d'un module d'alimentation des modules émetteurs, il peut s'agir :
   - d'une alimentation à distance des modules émetteurs à localiser (télé-alimentation)
   - d'une alimentation embarquée dans les modules émetteurs à localiser (par exemple batterie)

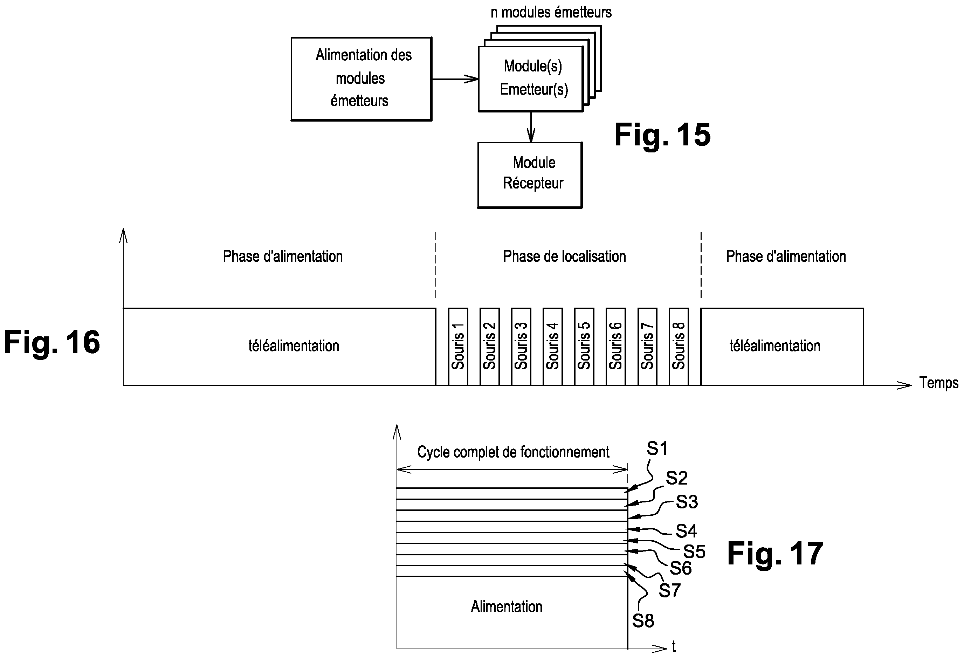

Sur la figure 15, on voit le principe de base du processus mis en oeuvre dans la présente invention. On alimente les n modules émetteurs qui à leur tour émettent un signal de localisation vers le module récepteur (la matrice de bobines réceptrices).

Sur la figure 16, on voit un premier mode de mise en oeuvre du procédé selon l'invention. Après une phase d'alimentation, chaque module attend un laps de temps donné avant d'émettre son signal de localisation. Les modules émetteurs émettent donc des réponses temporellement séparées. On peut imaginer dans ce cas que les signaux de localisation aient le même spectre s'il s'agit de signaux périodiques ou pseudopériodiques. En d'autres termes, on applique une identification de type TDMA (« Time Division Multiple Access ») : chaque module émet son signal de localisation dans le temps qui lui est imparti. Ainsi, si la cage contient 8 souris, 8 réponses sont reçues les unes à la suite des autres. Connaissant le délai de réponse associé à chaque module embarqué, il est possible d'identifier le module embarqué (méthode des slots temporels).

Sur la figure 17, on voit un deuxième mode de mise en oeuvre du procédé selon l'invention. Dans ce mode, la phase d'alimentation peut être superposée à la phase de localisation. On applique ici une identification de type FDMA (« Frequency Division Multiple Access ») : tous les modules embarqués émettent en même temps leurs signaux de localisation mais à des fréquences différentes. Connaissant la fréquence associée à chaque module émetteur (module embarqué), il est possible d'identifier indépendamment chaque module embarqué. Il s'agit d'une méthode de slots fréquentiels. Le cycle de fonctionnement peut être très court, mais cela nécessite beaucoup de ressource au niveau de l'unité de traitement pour discriminer les différentes fréquences.

En complément de ce qui précède, on peut associer un identifiant à chaque module embarqué. Pour s'identifier, chaque souris envoie un code unique. Pour ce faire, les deux méthodes ci-dessus peuvent être utilisées. Cependant contrairement aux deux solutions précédentes, les signaux envoyés comportent des informations (code unique de chaque souris) supplémentaires d'identification.

L'invention peut donc par exemple être mise en oeuvre pour la localisation de rongeurs, la localisation de doigts humains (gant comportant plusieurs modules émetteurs, un dans chaque doigt), la localisation d'objets par rapport à une surface (pions de jeu de société, etc.), la localisation d'objets sur une tablette graphique (avec par exemple un module émetteur au bout du stylet), etc.

Bien sûr, l'invention n'est pas limitée aux exemples qui viennent d'être décrits et de nombreux aménagements peuvent être apportés à ces exemples sans sortir du cadre de l'invention.

## Revendications

1. Procédé pour localiser au moins un élément mobile dans une zone prédéterminée, ce procédé comprenant les étapes suivantes :
- alimentation d'au moins un module embarqué dans l'élément mobile, ce module embarqué comprenant un circuit électronique et au moins une bobine embarquée,
- génération d'un signal de localisation par le circuit électronique et émission de ce signal de localisation via la bobine embarquée,
- capture du signal de localisation au moyen de bobines réceptrices réparties sur un support à proximité de la zone prédéterminée ; chaque bobine réceptrice ayant pour fonction de capter ledit signal de localisation lorsque l'élément mobile est à proximité,
- détermination de l'emplacement de l'élément mobile dans la zone prédéterminée par détection d'un niveau de signal sur ledit support qui est adressé en lignes et colonnes sous forme d'une matrice au moyen d'une unité de traitement reliée à ce support,
**caractérisé en ce qu'**il comprend les étapes suivantes pour la génération du signal de localisation :
- utilisation du circuit électronique et de la bobine embarquée comme circuit RLC oscillant, et
- interruption brusque du courant à travers la bobine embarquée de façon à générer le signal de localisation.

2. Procédé selon la revendication 1, **caractérisé en ce que** l'alimentation est effectuée de façon périodique ; en phase d'alimentation, on stocke de l'énergie dans chaque module embarqué pour une utilisation ultérieure en phase de non alimentation.

3. Procédé selon la revendication 1 ou 2, **caractérisé en ce que** la génération d'un signal de localisation est réalisée à un instant différent pour chaque module embarqué de façon à réaliser un multiplexage à accès multiple à répartition dans le temps (TDMA) pour distinguer les modules embarqués les uns des autres.

4. Procédé selon la revendication 1 ou 2, **caractérisé en ce que** la génération d'un signal de localisation est réalisée par génération d'un signal de fréquence prédéterminée et différente pour chaque module embarquée de façon à réaliser un multiplexage à accès multiple par répartition en fréquence (FDMA) pour distinguer les modules embarqués les uns des autres.

5. Procédé selon l'une quelconque des revendications précédentes, **caractérisé en ce que** chaque signal de localisation contient un identifiant unique.

6. Procédé selon l'une quelconque des revendications précédentes, **caractérisé en ce qu'**on réalise l'interruption brusque lorsque le courant a sa valeur la plus élevée.

7. Dispositif de localisation d'au moins un élément mobile dans une zone prédéterminée, ce dispositif comprenant :
- au moins un module embarqué dans l'élément mobile, ce module embarqué comprenant un circuit électronique et au moins une bobine embarquée pour émettre un signal de localisation,
- une alimentation de ce module embarqué,
- des bobines réceptrices réparties sur un support à proximité de la zone prédéterminée,
**caractérisé en ce que** chaque bobine réceptrice a pour fonction de capter ledit signal de localisation lorsque l'élément mobile est à proximité ; ce dispositif comprenant en outre :
- une unité de traitement reliée aux bobines réceptrices pour déterminer l'emplacement de l'élément mobile dans la zone prédéterminée par détection d'un niveau de signal sur ledit support qui est adressé en lignes et colonnes sous forme d'une matrice,
- le circuit électronique et la bobine embarquée constituant un circuit RLC oscillant, le circuit électronique étant configuré pour interrompre brusquement le courant à travers la bobine embarquée de façon à générer le signal de localisation.

8. Dispositif selon la revendication 7, **caractérisé en ce que** l'alimentation comprend un enroulement magnétique disposé à proximité de la zone prédéterminée de façon à alimenter à distance par champ magnétique chaque module embarqué.

9. Dispositif selon la revendication 7, **caractérisé en ce que** l'alimentation est constituée par la matrice de façon à alimenter à distance par champ magnétique chaque module embarqué.

10. Dispositif selon la revendication 8 ou 9, **caractérisé en ce que** le module embarqué comprend une bobine d'alimentation ayant pour fonction de capter le champ magnétique d'alimentation à distance.

11. Dispositif selon la revendication 10, **caractérisé en ce que** la bobine embarquée et la bobine d'alimentation constituent une même bobine.

12. Dispositif selon l'une quelconque des revendications 7 à 11, **caractérisé en ce que** le module embarqué comporte au moins trois bobines embarquées disposées en trièdre.

13. Dispositif selon l'une quelconque des revendications 7 à 12, **caractérisé en ce que** chaque bobine embarquée comporte un noyau de ferrite.

14. Dispositif selon la revendication 13, **caractérisé en ce que** le noyau de ferrite comprend des extrémités en demi-sphères.

## Patentansprüche

1. Verfahren zum Lokalisieren zumindest eines beweglichen Elements in einem vorbestimmten Bereich, wobei das Verfahren die folgenden Schritte umfasst:
- Versorgen von zumindest einem in dem beweglichen Element mitgeführten Modul, wobei dieses mitgeführte Modul eine elektronische Schaltung und zumindest eine mitgeführte Spule enthält,
- Erzeugen eines Ortungssignals durch die elektronische Schaltung und Ausgeben dieses Ortungssignals über die mitgeführte Spule,
- Erfassen des Ortungssignals mittels Empfängerspulen, die auf einem Träger in der Nähe des vorbestimmten Bereichs verteilt sind, wobei jede Empfängerspule dazu dient, das Ortungssignal zu erfassen, wenn sich das bewegliche Element in der Nähe befindet,
- Ermitteln der Stelle des beweglichen Elements in dem vorbestimmten Bereich durch Erfassen eines Signalpegels auf dem Träger, der in Zeilen und Spalten in Form einer Matrix mittels einer mit diesem Träger verbundenen Verarbeitungseinheit adressiert wird,
**dadurch gekennzeichnet, dass** es die folgenden Schritte zum Erzeugen des Ortungssignals umfasst:
- Verwenden der elektronischen Schaltung und der mitgeführten Spule als RLC-Schwingkreis und
- plötzliches Unterbrechen des Stroms durch die mitgeführte Spule, so dass das Ortungssignal erzeugt wird.

2. Verfahren nach Anspruch 1, **dadurch gekennzeichnet, dass** das Versorgen periodisch erfolgt; wobei während der Versorgungsphase Energie in jedem mitgeführten Modul für eine spätere Verwendung während einer Nichtversorgungsphase gespeichert wird.

3. Verfahren nach Anspruch 1 oder 2, **dadurch gekennzeichnet, dass** das Erzeugen eines Ortungssignals zu einem unterschiedlichen Zeitpunkt für jedes mitgeführte Modul erfolgt, um ein Zeitmultiplexing mit Mehrfachzugriff (TDMA) durchzuführen, um die mitgeführten Module voneinander zu unterscheiden.

4. Verfahren nach Anspruch 1 oder 2, **dadurch gekennzeichnet, dass** das Erzeugen eines Ortungssignals durch Erzeugen eines Signals mit einer vorgegebenen und unterschiedlichen Frequenz für jedes mitgeführte Modul erfolgt, um ein Frequenzmultiplexing mit Mehrfachzugriff (FDMA) durchzuführen, um die mitgeführten Module voneinander zu unterscheiden.

5. Verfahren nach einem der vorangehenden Ansprüche, **dadurch gekennzeichnet, dass** jedes Ortungssignal eine eindeutige Kennung enthält.

6. Verfahren nach einem der vorangehenden Ansprüche, **dadurch gekennzeichnet, dass** das plötzliche Unterbrechen dann erfolgt, wenn der Strom seinen höchsten Wert hat.

7. Vorrichtung zum Lokalisieren zumindest eines beweglichen Elements in einem vorbestimmten Bereich, wobei diese Vorrichtung enthält:
- zumindest ein in dem beweglichen Element mitgeführtes Modul, wobei dieses mitgeführte Modul eine elektronische Schaltung und zumindest eine mitgeführte Spule zum Ausgeben eines Ortungssignals enthält,
- eine Stromversorgung für dieses mitgeführte Modul,
- Empfängerspulen, die auf einem Träger in der Nähe des vorbestimmten Bereichs verteilt sind,
**dadurch gekennzeichnet, dass** jede Empfängerspule dazu dient, das Ortungssignal zu erfassen, wenn sich das bewegliche Element in der Nähe befindet;
wobei diese Vorrichtung ferner enthält:
- eine Verarbeitungseinheit, die mit den Empfängerspulen verbunden ist, um die Stelle des beweglichen Elements in dem vorbestimmten Bereich durch Erfassen eines Signalpegels auf dem Träger zu ermitteln, der in Zeilen und Spalten in Form einer Matrix adressiert wird,
- wobei die elektronische Schaltung und die mitgeführte Spule einen RLC-Schwingkreis bilden, wobei die elektronische Schaltung dazu ausgelegt ist, den Strom durch die mitgeführte Spule plötzlich zu unterbrechen, so dass das Ortungssignal erzeugt wird.

8. Vorrichtung nach Anspruch 7, **dadurch gekennzeichnet, dass** die Stromversorgung eine Magnetwicklung enthält, die in der Nähe des vorbestimmten Bereichs angeordnet ist, so dass jedes mitgeführte Modul durch ein Magnetfeld fernversorgt wird.

9. Vorrichtung nach Anspruch 7, **dadurch gekennzeichnet, dass** die Stromversorgung aus der Matrix besteht, so dass jedes mitgeführte Modul durch ein Magnetfeld fernversorgt wird.

10. Vorrichtung nach Anspruch 8 oder 9, **dadurch gekennzeichnet, dass** das mitgeführte Modul eine Stromversorgungsspule enthält, die dazu dient, das Fernversorgungsmagnetfeld zu erfassen.

11. Vorrichtung nach Anspruch 10, **dadurch gekennzeichnet, dass** die mitgeführte Spule und die Stromversorgungsspule dieselbe Spule bilden.

12. Vorrichtung nach einem der Ansprüche 7 bis 11, **dadurch gekennzeichnet, dass** das mitgeführte Modul zumindest drei mitgeführte Spulen aufweist, die in Form eines Trieders angeordnet sind.

13. Vorrichtung nach einem der Ansprüche 7 bis 12, **dadurch gekennzeichnet, dass** jede mitgeführte Spule einen Ferritkern enthält.

14. Vorrichtung nach Anspruch 13, **dadurch gekennzeichnet, dass** der Ferritkern halbkugelförmige Enden enthält.

## Claims

1. Method for locating at least one mobile element in a predetermined zone, this method comprising the following steps:
- supplying power to at least one on-board module in the mobile element, this on-board module comprising an electronic circuit and at least one on-board coil,
- generating a locating signal by the electronic circuit and transmission of this locating signal via the on-board coil,
- picking up the locating signal by means of receiver coils distributed on a support in proximity to the predetermined zone; each receiver coil having the function of picking up said locating signal when the mobile element is in proximity,
- determining the location of the mobile element in the predetermined zone by detecting a signal level on said support which is addressed in rows and columns in the form of an array by means of a processing unit connected to this support,
**characterized in that** the method comprises following steps for generating the locating signal:
- use of the electronic circuit and the on-board coil as an oscillating RLC circuit,
- sudden interruption of the current through the on-board coil in order to generate the locating signal.

2. Method according to claim 1, **characterized in that** power supply is carried out periodically; in the supply phase, energy is stored in each on-board module for later use in the non-supply phase.

3. Method according to claim 1 or 2, **characterized in that** the generation of a locating signal is carried out at a different time for each on-board module so as to carry out multiplexing with time-distributed multiple access (TDMA) in order to distinguish the on-board modules from one another.

4. Method according to claim 1 or 2, **characterized in that** the generation of a locating signal is carried out by generating a signal of a predetermined frequency that is different for each on-board module so as to carry out multiplexing with frequency-distributed multiple access (FDMA) in order to distinguish the on-board modules from one another.

5. Method according to any one of the preceding claims, **characterized in that** each locating signal contains a unique identifier.

6. Method according to any one of the preceding claims, **characterized in that** the sudden interruption is carried out when the current is at its highest value.

7. Device for locating at least one mobile element in a predetermined zone, said device comprising:
- at least one on-board module in the mobile element, this on-board module comprising an electronic circuit and at least one on-board coil for transmitting a locating signal,
- a power supply for this on-board module,
- receiver coils distributed on a support in proximity to the predetermined zone,
**characterized in that** each receiver coil has the function of detecting said locating signal when the mobile element is in proximity; this device further comprising:
- a processing unit connected to the receiver coils for determining the location of the mobile element in the predetermined zone by detecting a signal level on said support that is addressed in rows and columns in the form of an array,
- the electronic circuit and the on-board coil constituting an oscillating RLC circuit, the electronic circuit being configured in order to suddenly interrupt the current through the on-board coil so as to generate the locating signal.

8. Device according to claim 7, **characterized in that** the power supply comprises a magnetic winding arranged in proximity to the predetermined zone so as to supply each on-board module remotely, by magnetic field.

9. Device according to claim 7, **characterized in that** the power supply consists of the array, so as to supply each on-board module remotely, by magnetic field.

10. Device according to claim 8 or 9, **characterized in that** the on-board module comprises a supply coil having the function of picking up the remote power supply magnetic field.

11. Device according to claim 10, **characterized in that** the on-board coil and the power supply coil constitute one and the same coil.

12. Device according to any one of claims 7 to 11, **characterized in that** the on-board module comprises at least three on-board coils in a trihedral arrangement.

13. Device according to any one of claims 7 to 12, **characterized in that** each on-board coil comprises a ferrite core.

14. Device according to claim 13, **characterized in that** the ferrite core comprises hemispherical ends.
